# EUROPÄISCHE PATENTSCHRIFT

(11) **EP 1 437 932 B1**
(45) Veröffentlichungstag und Bekanntmachung des Hinweises auf die Patenterteilung: **01.12.2010**
(21) Anmeldenummer: 04008528.4
(22) Anmeldetag: 19.01.1998
(51) Int. Cl.: H05K 7/14, H02G 3/00, H02J 13/00

(54) **Gehäuse für ein EIB-Gerät**
Housing for an EIB-(European Installation bus) device
Boîtier pour un dispositif EIB

(30) Priorität: 21.01.1997 AT 8497
(43) Veröffentlichungstag der Anmeldung: 14.07.2004
(62) Teilanmeldung aus: 98890016.3
(73) Patentinhaber: Eaton GmbH, 3943 Schrems (AT)
(72) Erfinder: Zöchling, Martin, 3950 Gmünd (AT)
(74) Vertreter: Gibler, Ferdinand

(56) Entgegenhaltungen:
- EP-A- 0 547 532
- EP-A- 0 709 932
- DE-C- 4 140 611
- RIS H R: "EIB-BUS-EUROPAISCHER INSTALLATIONSBUS TEIL 2" , ELEKTROTECHNIK, VOGEL VERLAG K.G. WURZBURG, DE, NR. 7/8, PAGE(S) 61-67 , 1993 XP000567405 ISSN: 1431-9578 * Abbildung 1 *

## Beschreibung

Die Erfindung betrifft ein Gehäuse mit einem EIB-Gerät.

Der EIB (European Installation Bus) ist ein Bussystem, das zur Bedienung der in einem Gebäude installierten Elektrogeräte, wie z.B. Licht, Jalousien, Ventilatoren, Heizung, Alarmanlage od. dgl. konzipiert ist. Jeder Verbraucher und jedes Bedienungselement, wie z.B. Taster, Schalter, Dimmer od. dgl. wird mit einem entsprechenden Interface-Baustein, dem Busankoppler, versehen und an den als Zwei-Draht-Bus ausgeführten EIB angeschlossen. Beim EIB verfügt jeder Busteilnehmer über einen eigenen Mikroprozessor und kahn somit selbständig und unabhängig von einem zentralen Prozessor seine Daten verwalten. Wird z.B. ein Taster betätigt, der die Beleuchtung schalten soll, so sendet sein Busankoppler ein Datentelegramm auf den Datenbus. Alle Teilnehmer empfangen dieses Telegramm, jedoch nur die Steuerelektronik des betroffenen Gerätes, also der Beleuchtung, verarbeitet diese Daten weiter, betätigt ein Schaltorgan und verbindet damit die Beleuchtung mit dem Spannungsnetz. Die Datenübertragung und die Spannungsversorgung der Geräte erfolgt über ein einziges Adempaar.

Eine den EIB verwendende Installation kommt im Vergleich zur herkömmlichen Installation mit einer wesentlich geringeren Leitungsanzahl aus; ist einfacher zu erweitern und ist bedarfsweise durch einfache Umprogrammierung der Signalgeber und der Verbraucher in ihrer Funktion veränderbar.

Bislang wurden EIB-fähige Geräte relativ groß aufgebaut und lediglich für den Einbau in Schaltschränke oder in große Kabeltrassen, wie sie in Zweckbauten (Bürogebäude, öffentliche Gebäude) vorgesehen sind, konzipiert. Damit lastete dem an sich günstigen EIB der Nachteil des unverhältnismäßig hohen Platzbedarfs an.

In letzter Zeit wurde es -bedingt durch die Miniaturisierung der elektronischen Bauteilemöglich, die wesentlichen Komponenten von EIB-Geräten, nämlich Busankoppler und zugehörige Schaltorgan-Ansteuerelektronik entscheidend zu verkleinern, sodass an die Konstruktion von "kleinen" EIB-Geräten, die in herkömmlich Installationsdosen eingebaut werden können, gedacht werden kann.

Verbunden mit dieser kleinen Bauform ist das Problem, dass die Anschlüsse für den niedrige Gleichspannungen (Uₙₑₙₙ=29V) führenden Datenbus räumlich sehr nahe den Netzspannung führenden Geräteanschlüssen (Netzzuleitung, geschaltete Anschlüsse für die zu steuernden Verbraucher) rücken können und damit eine zur ausreichenden Isolierung dienende Beabstandung der Bus- von den netzseitigen Anschlüssen Schwierigkeiten bereitet.

Ein Gehäuse für ein EIB-Gerät ist etwa aus der EP 0 547 532 A bekannt.

Ziel der Erfindung ist es, ein Gehäuse für ein EIB-Gerät mit einem Busanschluss anzugeben, welches zumindest im Bereich des Busanschlusses eine Durchbrechung zur Durchführung von Stiften des Busanschlusses aufweist, dass ein genormter, mit Schwalbenschwanz versehener Busstecker, an welchen die beiden Busadern angeschlossen sind, besonders einfach an das EIB-Gerät angesteckt werden kann.

Erfindungsgemäß wird dies durch die Merkmale des Anspruchs 1 erreicht.

Der Busstecker kann damit im gut einsehbaren oberen Bereich des Gehäuses in die Schwalbenschwanzführung eingesetzt werden und entlang dieser bis zu den Stiften des Busanschlusses geführt werden.

Weitere vorteilhafte Ausführungsformen werden durch die Merkmale der Ansprüche 2 und 3 erzielt.

Die Erfindung wird nachstehend an Hand der in den Figuren dargestellten bevorzugten Ausführungsform näher erläutert. Es zeigt:
Fig.1 ein Blockschaltbild eines EIB-Gerätes;
Fig.2a,b,c die konstruktive Ausführung der Erfindung in Auf- Grundriss und Seitenriss;
Fig.3 ein erfindungsgemäßes Gehäuse für ein EIB-Gerät nach Fig.1 u. 2 und
Fig.4a,b das Gehäuse nach Fig.3 im Auf- und Grundriss.

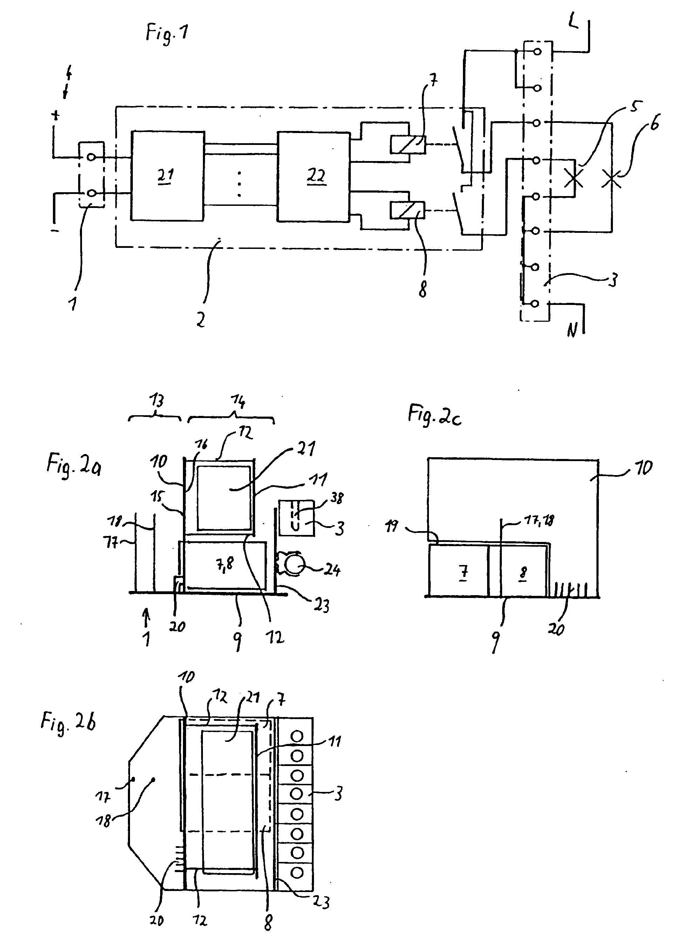

Wie am besten aus Fig.1 ersichtlich, weist ein EIB-Gerät die Baugruppen Busanschluss 1, Steuerelektronik 2 sowie Netz- und Verbraucheranschlüsse 3 auf. Die Steuerelektronik 2 kann noch unterteilt werden in Busankoppler 21 und Verbraucheransteuerschaltung 22. Der Busankoppler 21 überwacht den Bus 4 ständig und gibt -wie eingangs schon erwähnt- nur dann entsprechende Steueranweisungen an die Ansteuerschaltung 22 weiter, wenn das gerade empfangene Datenpaket tatsächlich an ihn adressiert ist. Die Ansteuerschaltung 22 hat nun die Aufgabe, die relativ energiearmen Steueranweisungen des Busankopplers 21 in tatsächliche Schalthandlungen umzusetzen. Im zur Erläuterung der Erfindung dienenden Beispiel soll das EIB-Gerät zwei Verbraucher 5,6 ein- und ausschalten, wozu Relais 7,8 verwendet werden.

Die Anschlüsse für den Phasen- L und den Neutralleiter N sind zum einen mit den Schaltkontakten der Relais 7,8, daneben aber auch jeweils mit einem zweiten Anschluss verbunden, Phasen- und Neutralleiter werden damit durch das EIB-Gerät durchgeschleift. Für den Anschluss weiterer Geräte an die Netzzuleitungen sind dadurch keine zusätzlichen, vom EIB-Gerät separate Klemmen erforderlich.

Ein EIB-Gerät mit einem derartigen Blockschaltbild soll nun zumindest so klein aufgebaut werden, dass es in eine Installationsdose eingebaut werden kann. Zur Erreichung dieses Zieles wird der in Fig.2 dargestellte Aufbau verwendet. Die Bauteile von Busankoppler 21 und

Ansteuerschaltung 22 werden dabei auf zumindest zwei Schaltungsträgerplatten 9,10 verteilt. Die erste Schaltungsträgerplatte 9 bildet dabei gleichsam die "Grundplatte" des EIB-Gerätes, die zumindest eine zweite Schaltungsträgerplatte 10 ist im wesentlichen rechtwinkelig zur ersten Schaltungsträgerplatte 9 verlaufend angeordnet und an dieser festgelegt. Diese Festlegung erfolgt vorzugsweise mithilfe der ohnehin notwendigen elektrischen Verbindungsleitungen 20, die als an sich bekannte rechtwinkelige Anschlusspins ausgebildet sind.

Ein EIB-Gerät wird so in eine Installationsdose eingesetzt, dass seine erste Schaltungsträgerplatte 9 parallel zum Boden der Installationsdose verläuft. Daher ist es günstig, diese Schaltungsträgerplatte 9 entsprechend dem Boden einer Installationsdose zu gestalten. Beim dargestellten Aufbau wurde eine Anpassung des Umrisses der Schaltungsträgerplatte 9 an den Boden einer runden Installationsdose in einfacher Weise dadurch erreicht, dass zwei Ecken einer an sich rechteckigen Schaltungsträgerplatte abgeschrägt wurden.

Der Busankoppler 22 ist als kompakte Baueinheit vorhanden, sämtliche seiner Bauteile sind auf einer weiteren, nicht direkt mit der zweiten Schaltungsträgerplatte 10 verbundenen weiteren Schaltungsträgerplatte 11 angeordnet. Die beiden Schaltungsträgerplatten 10 und 11 und damit Busankoppler 21 und Ansteuerschaltung 22 stehen über Verbindungsstifte 12 sowohl in elektrischer als auch in mechanischer Verbindung.

Die Bauteile der Ansteuerschaltung 21 sind mit Ausnahme der Relais 7,8, die direkt an der Grundplatte 9 unterhalb des Busankopplers 22 angeordnet sind, auf der zweiten Schaltungsträgerplatte 10 angebracht. Beim zur Erklärung der Erfindung gewählten Aufbau ist die Schaltungsträgerplatte 10 mit einer Ausnehmung 19 versehen, welche es ermöglicht, die Relais 7,8 abschnittsweise unterhalb der Schaltungsträgerplatte 10 anzuordnen.

Die in den Zeichnungen dargestellte eine zweite Schaltungsträgerplatte 10 kann bedarfsweise durch mehrere zueinander parallele und jede für sich an der ersten Schaltungsträgerplatte 9 festgelegte Schaltungsträgerplatten ersetzt werden. Desweiteren ist die Funktion eines EIB-Gerätes nicht auf die in Fig.1 dargestellte beschränkt, jedes EIB-Gerät kann unabhängig von seiner Funktion in der erfindungsgemäßen Weise aufgebaut werden.

Die zumindest eine zweite Schaltungsträgerplatte 10 teilt das EIB-Gerät in einen ersten, neben seiner ersten -in Fig. 2a,b der linken Seite 15- liegenden Bereich 13 und in einen zweiten, neben der zweiten (rechten) Seite 16 der Schaltungsträgerplatte 10 liegenden Bereich 14.

Der Busanschluss 1, der vorschriftsgemäß bei jedem EIB-Gerät aus zwei Stiften 17,18 zu bestehen hat, ist erfindungsgemäß im ersten Bereich 13, die Netz- und Verbraucheranschlüsse 3 sind hingegen im zweiten Bereich 14 angeordnet. Damit ist die zweite Schaltungsträgerplatte 10 zwischen Bus- 1 und Netz-/Verbraucheranschlüssen 3 angeordnet, diese weisen nicht nur den weitest möglichen räumlichen Abstand voneinander auf, sondern sind zusätzlich durch die Schaltungsträgerplatte 10 voneinander abgeschottet.

Wo und wie der Busanschluss 1 bzw. die Netz- und Verbraucheranschlüsse 3 in den genannten Bereichen angeordnet sind, ist prinzipiell beliebig. So könnten sie z.B. direkt auf der ersten 9 oder der zweiten Schaltungsträgerplatte 10 oder auf weiteren Schaltungsträgerplatten angeordnet sein. Besonders günstig hat es sich allerdings erwiesen, den Busanschluss 1 direkt an der ersten Schaltungsträgerplatte 9 so festzulegen, dass seine beiden Anschlussstifte 17, 18 senkrecht zu dieser verlaufen.

Netz- sowie Verbraucheranschlüsse 3 werden hingegen an einer dritten Schaltungsträgerplatte 23 angeordnet, welche dritte Schaltungsträgerplatte 23 im wesentlichen senkrecht zur ersten Schaltungsträgerplatte 9 verlaufend an dieser festgelegt ist. Diese dritte Schaltungsträgerplatte 23 bringt in zweifacher Hinsicht Vorteile für den Geräteaufbau: Zum einen können die Netz/Verbraucheranschlüsse 3 beabstandet von der ersten Schaltungsträgerplatte 9 angeordnet werden. Da das EIB-Gerät so in eine Installationsdose eingesetzt wird, dass die erste Schaltungsträgerplatte 9 am Boden der Installationsdose anliegt, rücken die Netz/Verbraucheranschlüsse 3, die vorzugsweise durch Federkraftklemmen gebildet sind, näher an die Öffnung der Installationsdose, sind damit für den Monteur leichter zugänglich und erlauben eine besonders einfache Verdrahtung des EIB-Gerätes.

Die Tatsache, dass die Federkraftklemmen zusätzlich dazu so auf der dritten Schaltungsträgerplatte 23 festgelegt sind, dass ihre Aufnahmekanäle 38 im wesentlichen senkrecht zur ersten Schaltungsträgerplatte 9 verlaufen, trägt ebenfalls zur Vereinfachung der Verdrahtung bei, diese kann dadurch nämlich auch dann, wenn das EIB-Gerät in der Installationsdose eingesetzt ist, problemlos vorgenommen werden.

Der zweite Vorteil der Verwendung einer dritten Schaltungsträgerplatte 23 für die Festlegung der Netz-/Verbraucheranschlüsse 3 liegt darin, dass auf ihr Bauteile der Busankoppelschaltung 22 angeordnet werden können. Bei der in den Zeichnungen dargestellten Ausführungsform der Erfindung wurde davon Gebrauch gemacht und eine Glasrohr-Sicherung 24, die zum Schutz der Verbraucheranschlüsse vor Überströmen dient, unterhalb der Netz-/Verbrauchanschlüsse 3 vorgesehen.

Besagte dritte Schaltungsträgerplatte 23 ist niedriger als die zumindest eine zweite Schaltungsträgerplatte 10 ausgeführt. Damit überragt die zweite Schaltungsträgerplatte 10 sowohl den Busanschluss 1 wie auch die Netz-/Verbrauchanschlüsse 3, wodurch eine besonders gute Abschottung der Bus- von der Netzseite gegeben ist.

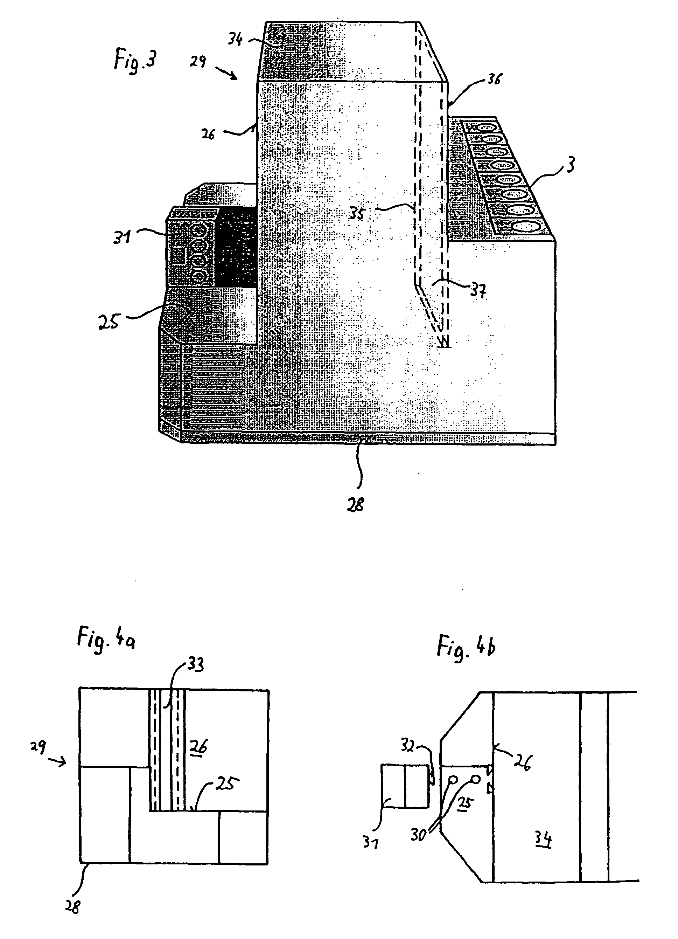

In den Fig.3 u. Fig. 4a,b ist ein erfindungsgemäßes Gehäuse für ein bislang beschriebenes EIB-Gerät dargestellt. Es umfasst eine parallel zur ersten Schaltungsträgerplatte 9 verlaufende Bodenplatte 28 sowie eine damit verbundene Gehäuseschale 29. Im Bereich des Busanschlusses 1 weist das Gehäuse einen parallel zur ersten Schaltungsträgerplatte 9 verlaufenden, mit zumindest einer Durchbrechung 30 zur Durchführung der Stifte 17,18 des Busanschlusses 1 versehenen ersten Abschnitt 25 auf. Daran anschließend ist ein parallel zu den Stiften 17,18 des Busanschlusses 1 verlaufender zweiter Abschnitt 26 vorgesehen.

Der Anschluss des Busses 4 an ein EIB-Gerät erfolgt vorschriftsgemäß über einen Stecker 31, an welchen die beiden Busadern angeschlossen sind. Dieser Stecker 31 weist -wie am besten aus Fig.4b ersichtlich- an einer seiner Seitenflächen einen Schwalbenschwanz 32 auf. Der zweite, parallel zu den Stiften 17,18 verlaufende Abschnitt 26 des Gehäuses ist mit einer Schwalbenschwanzführung 33, die sich zumindest über die Höhe der Stifte 17,18 erstreckt, ausgestattet. Beim Anstecken des Steckers 31 muss der Schwalbenschanz 32 in die zugehörige Führung 33 eingesetzt werden, wodurch eine Verpolung der Busadern verhindert wird.

Erfindungsgemäß ist der zweite Abschnitt 26 parallel zur zweiten Schaltungsträgerplatte 10 verlaufend und sich über deren gesamte Höhe erstreckend ausgebildet. Die hinsichtlich ihrer Funktion schon erläuterte Schalbenschwanzführung 33 ist erfindungsgemäß über die gesamte Höhe des zweiten Abschnittes 26 verlaufend ausgebildet. Der Stecker 31 kann dadurch am oberen Ende des Gehäuses, das leichter zugänglich ist, als die Stifte 17,18 des Busanschlusses 1 in die Schwalbenschwanzführung 33 eingesetzt werden, seine Buchsen sind dadurch bereits exakt fluchtend mit den Stiften 17,18 positioniert, sodass der Stecker 31 lediglich entlang der Schwalbenschwanzführung 33 bis zum Anliegen am ersten Gehäuse-Abschnitt 25 verschoben werden muss.

Der zweite Gehäuse-Abschnitt 26 setzt sich fort in einen dritten, parallel zur Bodenplatte 28 verlaufenden Abschnitt 34. Im Anschluss an diesen ist eine parallel zur zweiten Schaltungsträgerplatte 10 verlaufende Platte 35 vorgesehen, die in ihrem oberen Bereich 36 die Gebäudewandung bildet und sich mit ihrem unteren Bereich 37 ins Gehäuseinnere hineinerstreckt. Dieser untere Bereich 37 kommt zwischen der zweiten Schaltungsträgerplatte 9 und den Netz-/Verbraucheranschlüssen 3 zu liegen und bildet damit eine elektrische Isolation zwischen besagten beiden Bauteilen.

## Patentansprüche

1. Gehäuse mit einem EIB-Gerät, wobei das EIB-Gerät einen Busanschluss (1) aufweist, welches Gehäuse zumindest im Bereich des Busanschlusses (1) einen, mit zumindest einer Durchbrechung (30), durch welche Stifte (17,18) des Busanschlusses (1) durchgeführt sind, versehenen, ersten Abschnitt (25) sowie einen, parallel zu den Stiften (17,18) des Busanschlusses (1) verlaufenden zweiten Abschnitt (26) aufweist, welcher zweite Abschnitt (26) mit einer sich über die Höhe der Stifte (17,18) erstreckenden Schwalbenschwanzführung (33) versehenen ist, wobei die Schwalbenschwanzführung (33) über die gesamte Höhe des zweiten Abschnittes (26) verläuft, **dadurch gekennzeichnet, dass** das EIB-Gerät eine erste (9) und zumindest eine zweite Schaltungsträgerplatte (10) aufweist, welche einen im wesentlichen rechten Winkel miteinander einschließend aneinander festgelegt sind, dass der Busanschluss (1) an der ersten Schaltungsträgerplatte (9) festgelegt ist, dass der erste Abschnitt (25) parallel zur ersten Schaltungsträgerplatte (9) angeordnet ist, und dass sich der zweite Abschnitt (26) über die gesamte Höhe der zweiten Schaltungsträgerplatte (10) erstreckt.

2. Gehäuse nach Anspruch 1, **dadurch gekennzeichnet, dass** das EIB-Gerät einen Netzanschluss, Anschlüsse für anzusteuernde Verbraucher und/oder Sensoren (3) sowie eine Steuerelektronik (2) umfasst.

3. Gehäuse nach Anspruch 1, **dadurch gekennzeichnet, dass** der Busanschluss (1) im neben der ersten Seite (15) der zumindest einen zweiten Schaltungsträgerplatte (10) liegenden ersten Geräte-Bereich (13) und der Netzanschluss sowie die Verbrautheranschlüsse (3) im neben der anderen Seite (16) der zumindest einen zweiten Schaltungsträgerplatte (10) liegenden zweiten Geräte-Bereich (14) angeordnet sind,

4. Gehäuse nach einem der Ansprüche 1 bis 3, **dadurch gekennzeichnet, dass** der Busanschluss (1) an der ersten Schaltungsträgerplatte (9) im Wesentlichen senkrecht zu dieser verlaufend festgelegt ist.

## Claims

1. A housing with an EIB (European Installation Bus) device, with the EIB device comprising a bus connection (1), which housing comprises a first section (25) which is provided in the region of the bus connection (1) with at least one breakthrough (30), through which pins (17, 18) of the bus connection are guided, and a second section (26) extending parallel to the pins (17, 18) of the bus connection (1), which second section (26) is provided with a dovetail guide (33) extending over the height of the pins (17, 18), with the dovetail guide (33) extending over the entire height of the second section (26), **characterized in that** the EIB device comprises at least one first (9) and at least one second circuit support plate (10) which are fixed to one another at a substantially right angle with respect to one another, the bus connection (1) is fixed to the first circuit support plate (9), the first section (25) is arranged parallel to the first circuit support plate (9), and the second section (26) extends over the entire height of the second circuit support plate (10).

2. A housing according to claim 1, **characterized in that** the EIB device comprises a mains connection, connections for consumers and/or sensors (3) to be controlled and control electronics (2).

3. A housing according to claim 1, **characterized in that** the bus connection (1) is arranged in the first device region (13) disposed adjacent to the first side (15) of the at least one second circuit support plate (10), and the mains connection and the consumer connections (3) are arranged in the second device region (14) disposed adjacent to the other side of the at least one second circuit support plate (10).

4. A housing according to one of the claims 1 to 3, **characterized in that** the bus connection (1) is fixed to the first circuit support plate (9) by extending substantially perpendicular to the same.

## Revendications

1. Boîtier avec un module EIB, dans lequel le module EIB possède une connexion de bus (1), lequel boîtier présente au moins au niveau de la connexion de bus (1) une première partie (25) munie d'au moins une ouverture (30) à travers laquelle passent des broches (17, 18) de la connexion de bus (1), ainsi qu'une deuxième partie (26) parallèle aux broches (17, 18) de la connexion de bus (1), laquelle deuxième partie (26) est munie d'un guidage en queue d'aronde (33) s'étendant sur la hauteur des broches (17, 18), le guidage en queue d'aronde (33) s'étendant sur toute la hauteur de la deuxième partie (26), **caractérisé en ce que** le module EIB présente une première carte de circuits (9) et au moins une deuxième (10), qui sont fixées l'une sur l'autre en formant un angle sensiblement droit, **en ce que** la connexion de bus (1) est fixée sur la première carte de circuits (9), **en ce que** la première partie (25) est disposée parallèlement à la première carte de circuits (9) et **en ce que** la deuxième partie (26) s'étend sur toute la hauteur de la deuxième carte de circuits (10).

2. Boîtier selon la revendication 1, **caractérisé en ce que** le module EIB possède une connexion au réseau, des connexions de consommateurs et/ou de capteurs (3) à commander ainsi qu'une électronique de commande (2).

3. Boîtier selon la revendication 1, **caractérisé en ce que** la connexion de bus (1) est disposée dans la première zone de l'appareil (13) située près de la première face (15) de l'au moins une deuxième carte de circuits (10) et la connexion au réseau ainsi que les connexions des consommateurs (3) dans la deuxième zone de l'appareil (14) située près de l'autre face (16) de l'au moins une deuxième carte de circuits (10).

4. Boîtier selon l'une des revendications 1 à 3, **caractérisé en ce que** la connexion de bus (1) est fixée sur la première carte de circuits (9) de façon sensiblement perpendiculaire à celle-ci.
